# EUROPÄISCHE PATENTANMELDUNG

(11) **EP 2 592 916 A2**
(43) Veröffentlichungstag der Anmeldung: **15.05.2013**
(21) Anmeldenummer: 12182521.0
(22) Anmeldetag: 31.08.2012
(51) Int. Cl.: H05K 5/00

(54) **Elektrisches Steuergerät für ein Kraftfahrzeug**

(30) Priorität: 08.11.2011 DE 102011085924
(71) Anmelder: Robert Bosch GmbH, 70442 Stuttgart (DE)
(72) Erfinder: Zweigle, Peter, 71254 Ditzingen (DE); Bueyuekgoez, Harun, 72793 Pfullingen (DE); Falkenburger, Andreas, 72768 Reutlingen (DE); Mank, Erika, 74321 Bietigheim-Bissingen (DE); Deringer, Helmut, 74391 Erligheim (DE)

(57) **Zusammenfassung**

Die Erfindung geht aus von einem elektrischen Steuergerät für ein Kraftfahrzeug. Das Steuergerät (2) weist ein elektrisches Bauelement (20) mit wenigstens einem Anschlusspin (22), eine Zentrierplatte (12) und eine Leiterplatte (6) auf. Die Zentrierplatte (12) ist zwischen dem elektrischen Bauelement (20) und der Leiterplatte (6) angeordnet. Der wenigstens eine Anschlusspin (22) ist durch eine erste Öffnung (26) in der Zentrierplatte (12) und eine zweite Öffnung (30) in der Leiterplatte (6) geführt. Der wenigstens eine Anschlusspin (22) ist fest und elektrisch leitfähig an die Leiterplatte (6) verbunden. Erfindungsgemäß weist die Zentrierplatte (12) wenigstens eine technische Feder (38) auf. Durch die wenigstens eine technische Feder (38) ist die Zentrierplatte (12) derart an die Leiterplatte (6) gedrückt, dass kein Partikel zwischen der Leiterplatte (6) und der Zentrierplatte (12) hindurch zu dem Anschlusspin (22) gelangt.

## Beschreibung

### Stand der Technik

Zur Steuerung von diversen Anwendungen im Kraftfahrzeugbau sind elektronische Steuerungsgeräte erforderlich. Die elektronischen Steuergeräte enthalten elektronische Bauelemente wie Steuermodule zum Ansteuern von Aktuatoren, Sensoren sowie wenigstens eine Steckverbindung zum Anschluss an einen Fahrzeugkabelbaum. Zur Steuerung von modernen Automatikgetrieben sind elektronische Steuerungsmodule erforderlich, die in vielen Fällen im Inneren des Getriebegehäuses angeordnet sind. Hierbei werden die Steuermodule so verbaut, dass sie ganz oder teilweise von Getriebeöl bedeckt sind und Temperaturen von -40 °C bis +150 °C, die in derartigen Getrieben auftreten können, ausgesetzt sind. Um die empfindliche Elektronik vor dem Automatikgetriebeöl oder einem sonstigen das Steuergerät umgebenden Fluid zu schützen, wird die elektronische Schaltung in der Regel in einem gegenüber dem Fluid dichten Gehäuse untergebracht. Da Automatikgetriebeöl elektrisch nicht leitfähig ist, sind zwischenzeitlich Steuergeräte bekannt geworden, bei denen die Anschlusspins der elektrischen Bauelemente zumindest teilweise ungeschützt von dem Automatikgetriebeöl kontaktiert sind. Allerdings hat sich gezeigt, dass in dem Getriebeöl auftretende elektrisch leitfähige Verunreinigungen wie beispielsweise Metallspäne benachbarte Anschlusspins zeitgleich berühren und damit einen Kurzschluss hervorrufen können.

### Zusammenfassung der Erfindung

Somit kann ein Bedürfnis bestehen, ein Steuergerät für ein Kraftfahrzeug bereitzustellen, bei welchem die Anschlusspins von elektrischen Bauelementen gegenüber elektrisch leitfähigen Partikeln vor Kurzschluss geschützt sind.

Das Bedürfnis kann durch den Gegenstand des unabhängigen Patentanspruchs befriedigt werden. Weitere vorteilhafte Ausgestaltungen der Erfindung ergeben sich durch die Gegenstände der abhängigen Patentansprüche.

Gemäß einem ersten Ausgestaltungsbeispiel der Erfindung wird ein elektrisches Steuergerät für ein Kraftfahrzeug bereitgestellt. Das elektrische Steuergerät weist ein elektrisches Bauelement mit wenigstens einem Anschlusspin, eine Zentrierplatte und eine Leiterplatte auf. Die Zentrierplatte ist zwischen dem elektrischen Bauteil und der Leiterplatte angeordnet. Der wenigstens eine Anschlusspin ist durch eine erste Öffnung in der Zentrierplatte und eine zweite Öffnung in der Leiterplatte geführt. Der wenigstens eine Anschlusspin ist fest und elektrisch leitfähig an die Leiterplatte verbunden. Die Zentrierplatte weist wenigstens eine technische Feder auf. Durch die wenigstens eine technische Feder ist die Zentrierplatte derart an die Leiterplatte gedrückt, dass kein Partikel zwischen der Leiterplatte und der Zentrierplatte hindurch zu dem Anschlusspin gelangt.

Unter Partikel sind Feststoffe zu versehen. Partikel können beispielsweise metallischer Abrieb oder Metallspäne sein, die durch Schaltvorgänge innerhalb des Automatikgetriebes sowie Abwälzbewegungen von diesbezüglichen Zahnrädern erzeugt werden können. Dadurch, dass das elektrisch leitfähige Partikel nicht mehr zwischen der Leiterplatte und der Zentrierplatte hindurch zu zwei benachbarten Anschlusspins gelangen kann und die Anschlusspins brücken kann, wird wirkungsvoll ein Kurzschluss verhindert. Die technische Feder, die in vorteilhafter Weise die Zentrierplatte an die Leiterplatte drückt, kann beispielsweise eine Druckfeder, eine Zugfeder, eine Blattfeder, eine Spiralfeder oder auch eine Schenkelfeder sein. Die technische Feder kann als ein separates Bauteil ausgebildet sein. Auch kann die technische Feder fest an der Zentrierplatte verbunden sein. Die ersten Öffnungen in der Zentrierplatte besitzen an ihrer Oberseite in der Regel einen Einführtrichter, durch den der Anschlusspin in die erste Öffnung, die in der Regel als Bohrung ausgeführt ist, einführbar ist. Natürlich kann jedem Anschlusspin eine eigene erste Öffnung zugeordnet sein. Die ersten Öffnungen sind in ihrem Querschnitt in der Regel kleiner als die zweiten Öffnungen in der Leiterplatte, so dass beim Einsetzen des elektrischen Bauelements in die an der Leiterplatte montierte Zentrierplatte der Anschlusspin in der zweiten Öffnung allseitig von einer Wandung der zweiten Öffnung beabstandet sein kann, um eine optimale Lötung zu erzeugen. Natürlich kann das elektrische Steuergerät auch derart gestaltet sein, dass die Zentrierplatte vor dem Einsetzen des elektrischen Bauteils in die Leiterplatte an den Anschlusspins des elektrischen Bauelements montiert ist. Weiterhin ist in der Regel zumindest der Teilbereich der Zentrierplatte, der an der Leiterplatte in montiertem Zustand aufliegt, plan ausgebildet. Dieser Teilbereich kann auch die gesamte der Leiterplatte zugewandte Unterseite der Zentrierplatte umfassen. Der Teilbereich kann auch als ein umlaufender Rand ausgebildet sein, der gegen die Leiterplatte gedrückt wird. Der Rand kann als an der Zentrierplatte fest verbundene, elastische Dichtung ausgebildet sein. Hierbei kann die elastische Dichtung als ein Thermoplast ausgebildet sein, welches an die Unterseite der Zentrierplatte angespritzt ist.

Gemäß einem weiteren Ausgestaltungsbeispiel der Erfindung liegt die Zentrierplatte an der Leiterplatte spaltfrei an.

Gerade das spaltfreie Anliegen der Zentrierplatte an der Leiterplatte kann gewährleisten, dass kein Partikel, insbesondere elektrisch leitfähiger Feststoff, zwischen der Zentrierplatte und der Leiterplatte hindurch zu dem wenigstens einen Anschlusspin des Bauelements gelangen kann.

Gemäß einem weiteren Ausgestaltungsbeispiel der Erfindung stützt sich die wenigstens eine technische Feder an dem elektrischen Bauelement ab.

Die Abstützung kann hierbei mittelbar oder unmittelbar an dem elektrischen Bauelement erfolgen. Diese Ausgestaltung gestattet in vorteilhafter Weise, dass, wenn das elektrische Bauteil an die Leiterplatte verbunden wird, zugleich auch die Zentrierplatte an die Leiterplatte gedrückt wird. Somit sind keine weiteren Elemente erforderlich, um die Zentrierplatte an die Leiterplatte zu drücken. Gemäß einem weiteren Ausgestaltungsbeispiel der Erfindung sind die wenigstens eine technische Feder und die Zentrierplatte aus elektrisch nicht leitfähigem Kunststoff ausgebildet.

Durch eine derartige Ausgestaltung kann wirkungsvoll vermieden werden, dass durch die Zentrierplatte und/oder die wenigstens eine technische Feder eine elektrisch leitfähige Verbindung zwischen zwei oder mehreren Anschlusspins von einem oder zwei elektrischen Bauelementen geschaffen wird. Durch die Auswahl von Kunststoff als Material zur Herstellung der technischen Feder und der Zentrierplatte sind die technische Feder und die Zentrierplatte preisgünstig herzustellen. Insbesondere bei einer Ausgestaltung, so dass die technische Feder und die Zentrierplatte als Spritzgussteil ausgebildet sind, lassen sich diese beiden Teile in großer Stückzahl sehr preiswert produzieren.

Gemäß einem weiteren Ausgestaltungsbeispiel der Erfindung sind die wenigstens eine technische Feder und die Zentrierplatte einstückig ausgebildet.

Durch die einstückige Ausbildung wird zum einen der Montagevorgang derart erleichtert, dass ein Montieren der technischen Feder zwischen der Zentrierplatte und dem elektrischen Bauelement entfällt. Weiterhin wird durch die einstückige Ausbildung die Anzahl der zu montierenden Bauteile reduziert. Somit wird auch die Anzahl der in einem Lager vorzuhaltenden Einzelteile für das elektrische Steuergerät reduziert. Damit können die Herstellungskosten des elektrischen Steuergeräts reduziert werden.

Gemäß einem weiteren Ausgestaltungsbeispiel der Erfindung ist die wenigstens eine technische Feder im Wesentlichen halbbogenförmig ausgebildet.

Hierbei besitzt die technische Feder ein erstes Ende und ein dem ersten Ende gegenüberliegendes zweites Ende, wobei das erste und das zweite Ende durch einen Halbbogen verbunden sind. Natürlich könnte das erste Ende mit dem zweiten Ende auch durch beispielsweise Flachmaterial verbunden sein. Das erste Ende kann fest mit der Zentrierplatte verbunden sein. Damit kann sich das zweite Ende in einer ersten Position frei im Raum befinden. Bei der Montage des elektrischen Bauelements kann das zweite Ende aus der ersten Position relativ zu dem ersten Ende in eine zweite Position verlagert werden. Hierdurch kann eine auf die Zentrierplatte wirkende Kraft erzeugt werden, wobei die Kraft durch die Abmessungen der Andruckfeder und die Elastizität des Kunststoffs vorbestimmt ist. Die Andruckfedern können beispielsweise derart an der Zentrierplatte angeordnet sein, dass Kräfte, die quer zu einer Andrückrichtung auftreten, sich im Wesentlichen gegenseitig aufheben. Hierbei ist die Andrückrichtung die Richtung, in der das elektrische Bauelement an die Leiterplatte montiert wird. In der Regel ist die Andrückrichtung parallel zu der Längserstreckungsrichtung der zweiten Öffnungen in der Leiterplatte. Wenn beispielsweise die Zentrierplatte in der Aufsicht im Wesentlichen rechteckig ausgestaltet ist, kann beispielsweise in jeder Ecke eine Andruckfeder angeordnet sein, um einen gleichmäßigen Andruck der Zentrierplatte an die Leiterplatte sicherzustellen.

Gemäß einem weiteren Ausgestaltungsbeispiel der Erfindung weist die Zentrierplatte ein erstes Zentrierelement und die Leiterplatte ein mit dem ersten Zentrierelement korrespondierendes zweites Zentrierelement auf. Das erste Zentrierelement und das zweite Zentrierelement wirken derart zusammen, dass die Zentrierplatte in einer vorbestimmten Position an die Leiterplatte verbunden ist.

Um die vorbestimmte Position an der Leiterplatte sicherzustellen, können beispielsweise an der Zentrierplatte zwei kreiszylinderförmige Zapfen als das erste Zentrierelement ausgebildet sein, welches mit dem zweiten Zentrierelement derart zusammmenwirkt, dass jeder kreiszylindrische Zapfen in eine korrespondierende Öffnung, die als einfach herzustellende Bohrung ausgebildet sein kann, in der Leiterplatte greift. Damit die Zapfen besser in die korrespondierende Öffnungen finden, können die Zapfen zur Leiterplatte hin kegelförmig oder trompetenförmig ausgestaltet sein. Auch kann die vorbestimmte Positionierung der Zentrierplatte an der Leiterplatte dadurch erfolgen, dass zum Toleranzausgleich die zu dem einen Zapfen korrespondierende Öffnung in der Leiterplatte als Bohrung, und die andere zu dem Zapfen korrespondierende Öffnung als Langloch ausgebildet ist. Weiterhin können zum Toleranzausgleich in der Leiterplatte beispielsweise zwei Bohrungen vorgesehen sein, während die Zentrierplatte lediglich einen Zapfen und einen Schwertstift mit beispielsweise elliptischem Querschnitt aufweist. Auch kann das erste Zentrierelement mit dem korrespondierenden zweiten Zentrierelement derart zusammenwirken, das das erste und das zweite Zentrierelement zueinander eine Spielpassung oder eine spielfreie Passung aufweisen.

Gemäß einem weiteren Ausgestaltungsbeispiel der Erfindung weist die Zentrierplatte einer der Leiterplatte zugewandte Unterseite auf. Die Unterseite weist wenigstens eine Aussparung auf, wobei sich die erste Öffnung bis zu der Aussparung erstreckt.

Beim Löten des wenigstens einen Anschlusspins an die der Bestückungsseite gegenüberliegenden Unterseite oder Lötseite der Leiterplatte steigt durch die Kapillarwirkung das Lot durch die zweite Bohrung in Richtung des elektrischen Bauelements auf und bildet in erkaltetem Zustand sowohl an der Lötseite als auch an der Bestückungsseite der Leiterplatte im Idealfall einen hydrostatischen Meniskus aus. Insbesondere die Ausbildung des hydrostatischen Meniskus an der Bestückungsseite der Leiterplatte verbessert zusätzlich die Festigkeit und damit die Belastbarkeit der Lötung oder Lötstelle. In vorteilhafter Weise ermöglicht die Aussparung die Bildung eines derartigen hydrostatischen Meniskus an der Bestückungsseite der Leiterplatte.

Gemäß einem weiteren Ausgestaltungsbeispiel der Erfindung weist die Leiterplatte eine dem elektrischen Bauelement zugewandte Bestückungsseite auf. Die Zentrierplatte weist eine von der Bestückungsseite abgewandte Oberseite auf. In der Zentrierplatte sind wenigstens zwei voneinander beabstandete erste Öffnungen angeordnet. Zwischen je zwei einander benachbarten ersten Öffnungen erstreckt sich eine Trennrippe. Die Trennrippe ist auf der Oberseite der Zentrierplatte ausgebildet. Die Trennrippe erstreckt sich im Wesentlichen senkrecht von der Bestückungsseite weg.

In der Regel wird die Trennrippe derart ausgestaltet sein, dass sie das Gehäuse des elektrischen Bauelements berührt oder nur minimal von diesem beabstandet ist. Auch kann sie derart ausgestaltet sein, dass sie parallel zu den aus dem Gehäuse des elektrischen Bauelements heraustretenden Anschlusspins angeordnet ist. Die Trennrippe kann höher ausgestaltet sein als der höchste Punkt der montierten Anschlusspins über die Oberseite der Zentrierplatte übersteht. Ferner kann die Trennrippe länger ausgestaltet sein als sich die an die Leiterplatte verbundenen Anschlusspins von dem elektrischen Bauelement weg erstrecken. Durch eine derartige Trennrippe kann sichergestellt werden, dass beispielsweise ein metallischer Span nicht gleichzeitig mehr als einen sich an der Oberseite der Zentrierplatte erstreckenden Anschlusspin berühren kann. Natürlich können die einander benachbarten Trennrippen an einer dem Gehäuse des elektrischen Bauelements gegenüberliegenden Seite mittels einer Trennwand miteinander verbunden sein.

Gemäß einem weiteren Ausgestaltungsbeispiel der Erfindung ist die Trennrippe derart ausgebildet, dass zwei benachbarte Anschlusspins an der Oberseite der Zentrierplatte nicht durch einen elektrisch leitfähigen Span verbindbar sind.

Gemäß einem weiteren Ausgestaltungsbeispiel der Erfindung weist das elektrische Steuergerät eine Zentrierplattenanordnung auf. Die Zentrierplattenanordnung weist wenigstens zwei Zentrierplatten und wenigstens ein elastisch verformbares Element auf, wobei die wenigstens zwei Zentrierplatten durch das wenigstens eine elastisch verformbare Element miteinander unlösbar verbunden sind.

Mittels der an jeder Zentrierplatte ausgeformten Zentrierelemente kann jede Zentrierplatte an der Leiterplatte in einer vorbestimmten Position fest verbunden werden. Aufgrund unterschiedlicher Temperaturausdehnungskoeffizienten von Leiterplatte und Zentrierplattenanordnung werden die einzelnen Zentrierplatten relativ zueinander bewegt. Das elastische, reversibel verformbare Element kann in vorteilhafter Weise sicherstellen, dass aufgrund der Relativbewegung der einzelnen Zentrierplatten zueinander durch das sie verbindende elastisch verformbare Element im Wesentlichen keine Kräfte auf die Zentrierplatten aufgebracht werden, die sich an die an der Leiterplatte angelöteten Anschlusspins übertragen könnten. Derartige auf die Anschlusspins wirkende Kräfte könnten die Haltbarkeit der Lötstellen negativ beeinflussen. Beispielsweise können die elastischen, reversibel verformbaren Elemente bogenförmig oder S-förmig ausgebildet sein.

Gemäß einem weiteren Ausgestaltungsbeispiel der Erfindung ist die Zentrierplattenanordnung einstückig ausgebildet ist.

Damit ist es möglich, für jede Leiterplatte lediglich eine einzige Zentrierplattenanordnung vorzusehen. Die Zentrierplattenanordnung kann derart gestaltet sein, dass beliebig viele elektrische Bauelemente an der Zentrierplattenanordnung angeordnet werden können.

Gemäß einem weiteren Ausgestaltungsbeispiel der Erfindung ist die Zentrierplattenanordnung aus nicht leitfähigem Kunststoff als Spritzgussteil ausgebildet.

Somit ist es in vorteilhafter Weise möglich, eine derartige Zentrierplattenanordnung kostengünstig herzustellen.

Gemäß einem weiteren Ausgestaltungsbeispiel der Erfindung weist die Zentrierplatte dritte Zentrierelemente zur zentrierten Aufnahme wenigstens eines Bauelements auf.

Derartig ausgebildete dritte Zentrierelemente in Verbindung mit dem wenigstens einen elektrischen Bauelement sind in der Lage, während des Betriebs auf das elektrische Bauelement wirkende Querkräfte aufzunehmen, und in die Leiterplatte einzuleiten. Insbesondere bei einer Ausführung als Presspassung kann es vorteilhaft sein, die beispielsweise als Zapfen ausgebildeten dritten Zentrierelemente innen hohl auszubilden. Auch können derartige Zapfen beispielsweise entlang ihrer Längserstreckungsrichtung Ausnehmungen aufweisen, so dass die Zapfen nur auf einzelnen Teilzylinderflächen tragen. Natürlich ist es auch möglich, die Presspassung sowohl gegenüber dem elektrischen Bauelement als auch gegenüber der Leiterplatte zu erzeugen. Insbesondere eine Ausgestaltung, bei der alle Zentrierelemente als Presspasung ausgebildet sind, kann bewirken, dass keine auf das elektrische Bauelement wirkende Querkräfte in die Lötstelle des Anschlusspins an die Leiterplatte eingtragen werden kann. Vielmehr werden bei einer derartigen Ausgestaltung die Querkräfte von dem elektrischen Bauteil über die driten Zentrierelemente in die Zentrierplatte und von dort mittes der ersten und zweiten Zentrierelemente in die Leiterplatte eingetragen.

Es wird angemerkt, dass Gedanken zu der Erfindung hierin im Zusammenhang mit einer elektrischen Steuereinheit beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Fig. 1: zeigt ein Steuergerät in einer Explosionsdarstellung;
- Fig. 2: zeigt eine Unterseite einer Zentrierplattenanordnung in einer 3-D-Ansicht; und
- Fig. 3: zeigt eine Oberseite der aus Fig. 2 bekannten Zentrierplattenanordnung in einer 3-D-Ansicht.

### Detaillierte Beschreibung einer beispielhaften Ausführungsform

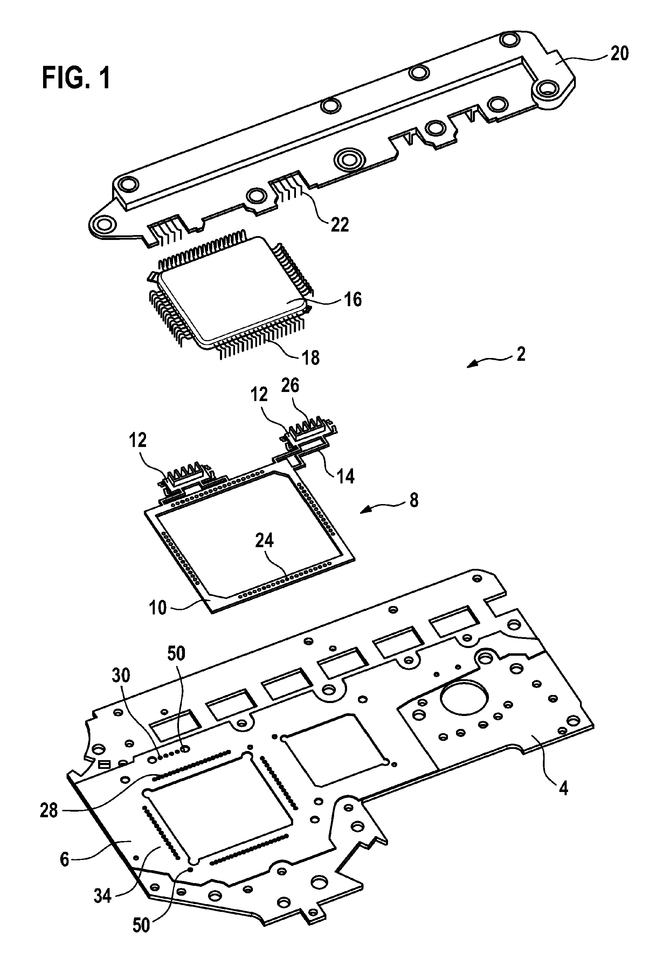

Fig. 1 zeigt ein Steuergerät 2 in einer Explosionsdarstellung. An einer Trägerplatte 4 ist eine Leiterplatte 6 fest verbunden. An die Leiterplatte 6 ist eine Zentrierplattenanordnung 8 lösbar verbindbar. Die Zentrierplattenanordnung 8 besteht im Wesentlichen aus einem Zentrierrahmen 10 sowie zwei Zentrierplatten 12. Die beiden Zentrierplatten 12 sind an dem Zentrierrahmen 10 mittels elastischer, reversibel verformbarer Elemente 14 verbunden. An den Zentrierrahmen 10 ist ein erstes elektrisches Bauelement 16 mit etwa siebzig ersten Anschlusspins 18 verbindbar. An die beiden Zentrierplatten 12 ist ein zweites elektrisches Bauelement 20 mit insgesamt acht zweiten Anschlusspins 22 verbindbar. Zur Montage wird die Zentrierplattenanordnung 8 an der Leiterplatte 6 angeordnet und die ersten Anschlusspins 18 des ersten elektrischen Bauelements 16 durch erste Öffnungen 24 im Zentrierrahmen 10 sowie zweite Öffnungen 28 in der Leiterplatte 6 eingeführt. Weiterhin werden die zweiten Anschlusspins 22 des zweiten elektrischen Bauelements 20 durch erste Öffnungen 26 in der Zentrierplatte 12 sowie zweite Öffnungen 30 in der Leiterplatte 6 hineingeführt. In der Regel ist ein erster Querschnitt der ersten Öffnung 24, 26 kleiner als ein zweiter Querschnitt der zweiten Öffnung 28, 30. Die beiden elektrischen Bauelemente 16, 20 werden an den Zentrierrahmen 10 bzw. die Zentrierplatte 12 gedrückt und in diesem gedrückten Zustand, der beispielweise durch einen Lötrahmen erzeugt werden kann, an einer hier nicht dargestellten Lötseite der Leiterplatte 6 mit der Leiterplatte 6 verlötet. Hierbei liegt die Zentrierplattenanordnung 8 an einer Bestückungsseite 34 der Leiterplatte 6 spaltfrei an.

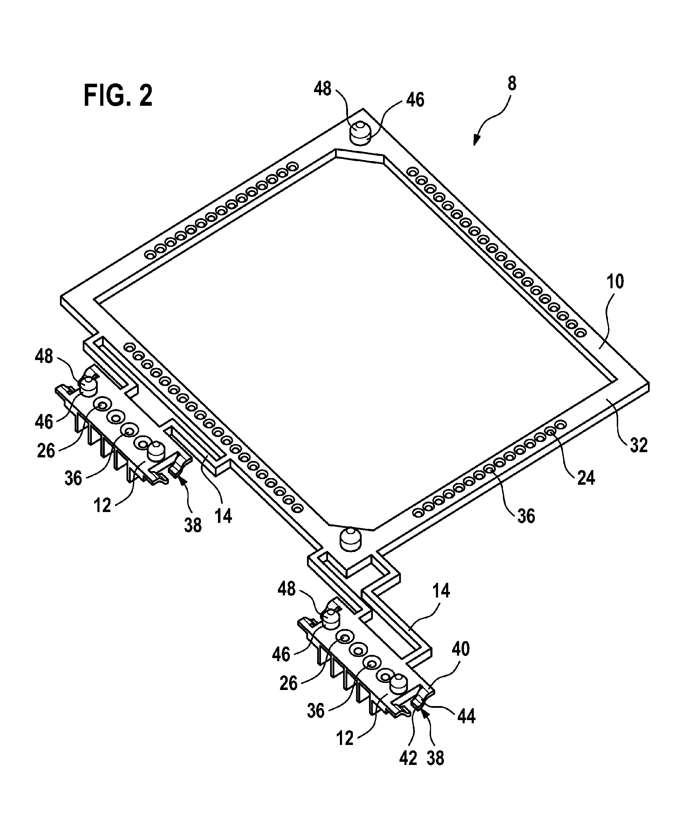

Fig. 2 zeigt eine der Bestückungsseite 34 benachbarte Unterseite 32 der Zentrierplattenanordnung 8 in einer 3-D-Ansicht. In montiertem Zustand liegt die Unterseite 32 an der Bestückungsseite 34 der Leiterplatte 6 derart an, dass, wenn das elektrische Steuergerät mit Automatikgetriebeöl in Verbindung kommt, kein Partikel in Form von elektrisch leitfähigen Verunreinigungen oder einem Metallspan zwischen der Bestückungsseite 34 und der Unterseite 32 zu den ersten 18 bzw. zweiten Anschlusspins 22 gelangen kann. Deutlich sichtbar in der hier gewählten Darstellung ist, dass die elastischen, reversibel verformbaren Elemente 14 derart ausgelegt sind, dass die Zentrierplatten 12 gegenüber dem Zentrierrahmen 10 nahezu kraftfrei bewegbar sind. Hierzu sind die elastischen, reversibel verformbaren Elemente 14 im Wesentlichen S-förmig ausgebildet. Die Unterseite 32 besitzt ferner im Wesentlichen kegelförmige Aussparungen 36, wobei sich jede erste Öffnung 24, 26 zu ihrer zugehörigen Aussparung 36 erstreckt. Die Aussparungen 36 an der Unterseite 32 stellen sicher, dass sich an der Bestückungsseite 34 der Leiterplatte 6 zu den elektrischen Bauelementen 16, 20 hin an den Anschlusspins 18, 22 je ein hydrostatischer Meniskus ausbilden kann. Insbesondere die Ausbildung von hydrostatischen Menisken an der Bestückungsseite 34 der Leiterplatte 6 stellen eine haltbare und qualitativ hochwertige Lötstelle sicher. An jeder Zentrierplatte 12, die im vorliegenden Ausführungsbeispiel im Wesentlichen rechteckig ausgebildet ist, ist im Wesentlichen an jeder Ecke eine technische Feder ausgebildet. Die technische Feder 34 besitzt ein erstes Ende 40 und ein dem ersten Ende 40 gegenüberliegendes zweites Ende 42. Das erste Ende 40 ist mit dem zweiten Ende 42 mittels eines Halbbogens 44 verbunden. Hierbei sind an jeder Schmalseite der Zentrierplatte 12 zwei zueinander spiegelbildlich ausgebildete technische Federn 38 angeordnet. Das erste Ende 40 ist mit der Zentrierplatte 12 unlösbar verbunden, während das zweite Ende 42 frei im Raum steht. Wenn das zweite elektrische Bauelement 20 an die an die Leiterplatte 6 verbundene Zentrierplatte 12 montiert wird, drückt das zweite elektrische Bauelement die zweiten Enden 42 in Richtung der Bestückungsseite 34 der Leiterplatte 6. Hierdurch wird der Halbbogen 44 elastisch verformt bzw. vorgespannt. Die durch die Vorspannung des Halbbogens 44 erzeugte Kraft wird über das erste Ende 40 in die Zentrierplatte 12 eingeleitet. Diese Kraft bewirkt, dass die Unterseite 32 der Zentrierplatte 12 an die Bestückungsseite 34 der Leiterplatte 6 spaltfrei gedrückt wird. Weiterhin ist in Fig. 2 ersichtlich, dass sowohl an der Unterseite 32 des Zentrierrahmens 10 als auch der Unterseite 32 der Zentrierplatten 12 jeweils als Zapfen ausgebildete erste Zentrierelemente 46 ausgeformt sind. Die ersten Zentrierelemente 46 besitzen an der der Bestückungsseite 34 zugewandten Seite je eine kegelförmige Verjüngung 48. Diese kegelförmige Verjüngung 48 erlaubt ein einfaches Einführen der ersten Zentrierelemente 46 in zu den ersten Zentrierelementen 46 korrespondierende zweite Zentrierelemente 50, wobei die zweiten Zentrierelemente 50 als Bohrung in der Leiterplatte 6 ausgebildet sind. Wenn die Zentrierplattenanordnung 8 an die Leiterplatte 6 montiert wird, wirken die Zentrierelemente 46, 50 derart zusammen, dass der Zentrierrahmen 10 sowie die Zentrierplatten 12 an der Leiterplatte 6 vorbestimmt positioniert sind. Die elastischen, reversibel verformbaren Elemente 14 ermöglichen hierbei, dass die Zentrierplatten 12 und die Zentrierrahmen 10 relativ zueinander bewegbar sind. Somit können sich die Zentrierplatten 12 und der Zentrierrahmen 10 relativ zueinander bewegen, wie dies beispielsweise aufgrund unterschiedlicher Temperaturausdehnungskoeffizienten von für die Leiterplatte 6 und die Zentrieplattenanordnung 8 verwendeten Materialien der Fall sein kann. In vorteilhafter Weise wird ermöglicht, dass pro Leiterplatte 6 lediglich eine Zentrierplattenanordnung 8 benötigt wird, um beliebig viele elektrische Bauelemente 16, 20 an der Leiterplatte 6 in einer vorbestimmten Position anzuordnen.

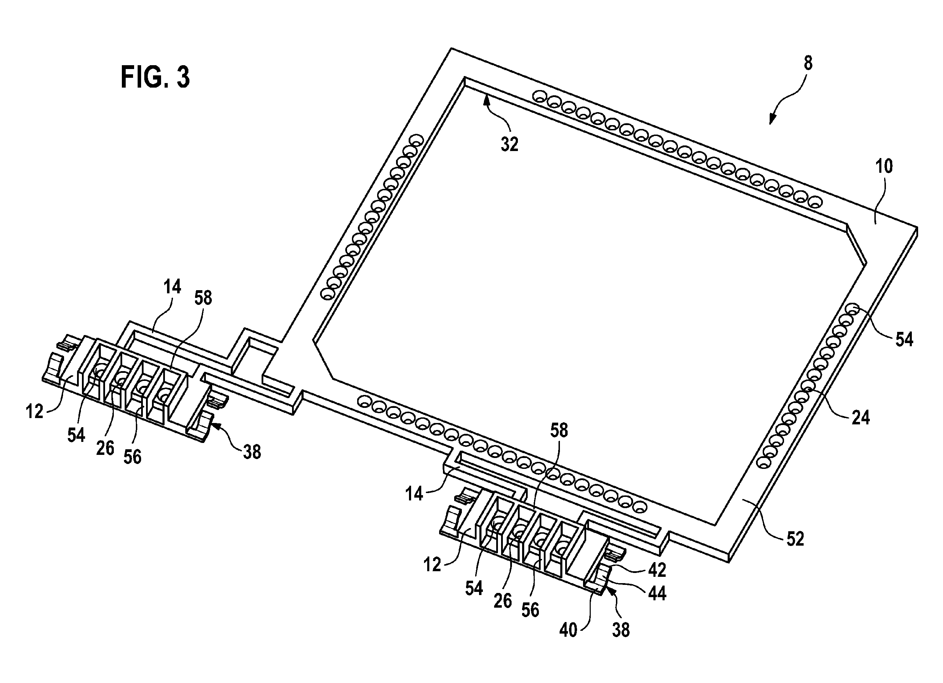

Fig. 3 zeigt eine der Unterseite 32 gegenüberliegende Oberseite 52 der aus Fig. 2 bekannten Zentrierplattenanordnung 8 ebenfalls in einer 3-D-Ansicht. Hierbei ist jede der ersten Öffnungen 24, 26 mit einem Einführkegel 54 verbunden. Der Einführkegel 54 stellt sicher, dass, wenn die elektrischen Bauelemente 16, 20 an die Zentrierplattenanordnung 8 montiert werden, deren Anschlusspins 18, 22 durch den Einführkegel 54 in die ersten Öffnungen 24, 26 gelenkt werden, um von den ersten Öffnungen 24, 26 in die zweiten Öffnungen 28, 30 der Leiterplatte 6 zu gelangen. Zwischen zwei einander benachbarten ersten Öffnungen 26 jeder Zentrierplatte 12 erstrecken sich je eine Trennrippe 56. Die Trennrippen 56 erstrecken sich bezüglich der Oberseite 52 höher als der höchste Punkt der zweiten Anschlusspins 22 in montiertem Zustand. Weiterhin erstrecken sich die Trennrippen 56 von dem zweiten elektrischen Bauelement 20 in montiertem Zustand weiter weg als die zweiten Anschlusspins 22. Somit kann ein metallischer Span in montiertem Zustand des elektrischen Steuergeräts 2 nicht gleichzeitig zwei zweite Anschlusspins 22 berühren und damit einen Kurzschluss erzeugen. Im Übrigen ist jeder zweite Anschlusspin 22 durch zwei einander gegenüberliegende Trennrippen 56 flankiert. Weiterhin sind alle Trennrippen 56 einer Zentrierplatte 12 an einer von dem zweiten elektrischen Bauelement 20 abgewandten Seite mittels einer Trennwand 58 miteinander unlösbar verbunden. Die Zentrierplattenanordnung 8 ist in dem vorliegenden Ausgestaltungsbeispiel aus elektrisch nicht leitfähigem Kunststoff hergestellt. Weiterhin wird die Zentrierplattenanordnung 8 besonders preisgünstig im Spritzgussverfahren hergestellt.

Die an die Leiterplatte 6 angeordnet Zentrierplattenanordnung 8 stellt sicher, dass elektrische Bauelemente 16, 20 automatisiert mit der Leiterplatte elektrisch leitfähig verbunden werden können. In vorteilhafter Weise wird durch die technischen Federn 38 bewirkt, dass nach der Montage der elektrischen Bauelemente 16, 20 die Unterseiten 32 der Zentrierplatten 12 an die Bestückungsseite 34 der Leiterplatte 6 derart spaltfrei angedrückt sind, dass ein Eindringen eines Partikels in Form einer elektrisch leitfähigen Verunreinigung oder eines Spans in dem Automatikgetriebeöl zwischen der Zentrieplatte 12 und der Leiterplatte hindurch zu dem Anschlusspin 22 sicher vermieden wird.

## Patentansprüche

1. Elektrisches Steuergerät für ein Kraftfahrzeug, wobei das elektrische Steuergerät (2) ein elektrisches Bauelement (20) mit wenigstens einem Anschlusspin (22), eine Zentrierplatte (12) und eine Leiterplatte (6) aufweist, wobei die Zentrierplatte (12) zwischen dem elektrischen Bauelement (20) und der Leiterplatte (6) angeordnet ist
wobei der wenigstens eine Anschlusspin (22) durch eine erste Öffnung (26) in der Zentrierplatte (12) und eine zweite Öffnung (30) in der Leiterplatte (6) geführt ist,
wobei der wenigstens eine Anschlusspin (22) fest und elektrisch leitfähig an die Leiterplatte (6) verbunden ist,
**dadurch gekennzeichnet, dass**
die Zentrierplatte (12) wenigstens eine technische Feder (38) aufweist, wobei durch die wenigstens eine technische Feder (38) die Zentrierplatte (12) derart an die Leiterplatte (6) gedrückt ist, dass kein Partikel zwischen der Leiterplatte (6) und der Zentrierplatte (12) hindurch zu dem Anschlusspin (22) gelangt.

2. Elektrisches Steuergerät nach Anspruch 1,
**dadurch gekennzeichnet, dass**
sich die wenigstens eine technische Feder (38) an dem elektrischen Bauelement (20) abstützt.

3. Elektrisches Steuergerät nach Anspruch 2,
**dadurch gekennzeichnet, dass**
die wenigstens eine technische Feder (38) und die Zentrierplatte (12) aus elektrisch nicht leitfähigem Kunststoff ausgebildet sind.

4. Elektrisches Steuergerät nach Anspruch 2 oder 3,
**dadurch gekennzeichnet, dass**
die wenigstens eine technische Feder (38) und die Zentrierplatte (12) einstückig ausgebildet sind.

5. Elektrisches Steuergerät nach einem der vorhergehenden Ansprüche, **dadurch gekennzeichnet, dass**
die Zentrierplatte (12) ein erstes Zentrierelement (46) und die Leiterplatte (6) ein mit dem ersten Zentrierelement (46) korrespondierendes zweites Zentrierelement (50) aufweist, wobei das erste Zentrierelement (46) und das zweite Zentrierelement (50) derart zusammenwirken, dass die Zentrierplatte (12) in einer vorbestimmten Position an die Leiterplatte (6) verbunden ist.

6. Elektrisches Steuergerät nach einem der vorhergehenden Ansprüche, **dadurch gekennzeichnet, dass**
die Zentrierplatte (12) eine der Leiterplatte (6) zugewandte Unterseite (32) aufweist,
wobei die Unterseite (32) wenigstens eine Aussparung (36) aufweist, wobei sich die erste Öffnung (26) bis zu der Aussparung (36) erstreckt.

7. Elektrisches Steuergerät nach einem der vorhergehenden Ansprüche, **dadurch gekennzeichnet, dass**
die Leiterplatte (6) eine dem elektrischen Bauelement (16, 20) zugewandte Bestückungsseite (34) aufweist,
wobei die Zentrierplatte (12) eine von der Bestückungsseite (34) abgewandte Oberseite (52) aufweist,
wobei in der Zentrierplatte (12) wenigstens zwei voneinander beabstandete erste Öffnungen (26) angeordnet sind,
wobei sich zwischen je zwei einander benachbarten ersten Öffnungen (26) eine Trennrippe (56) erstreckt,
wobei die Trennrippe (56) auf der Oberseite (52) der Zentrierplatte (12) ausgebildet ist,
wobei sich die Trennrippe (56) im Wesentlichen senkrecht von der Bestückungsseite (34) weg erstreckt.

8. Elektrisches Steuergerät nach Anspruch 7,
**dadurch gekennzeichnet, dass**
die Trennrippe (56) derart ausgebildet ist, dass zwei benachbarte Anschlusspins (22) an der Oberseite (52) der Zentrierplatte (12) nicht durch einen elektrisch leitfähigen Span verbindbar sind.

9. Elektrisches Steuergerät nach einem der vorhergehenden Ansprüche, **dadurch gekennzeichnet, dass**
das elektrische Steuergerät (2) eine Zentrierplattenanordnung (8) aufweist, wobei die Zentrierplattenanordnung (8) wenigstens zwei Zentrierplatten (12) und wenigstens ein elastisch verformbares Element (14) aufweist, wobei die wenigstens zwei Zentrierplatten (12) durch das wenigstens eine elastisch verformbare Element (14) miteinander unlösbar verbunden sind.

10. Elektrisches Steuergerät nach Anspruch 9,
**dadurch gekennzeichnet, dass**
die Zentrierplattenanordnung (8) einstückig ausgebildet ist.
